# EUROPEAN PATENT SPECIFICATION

(11) **EP 4 286 669 B1**
(45) Date of publication and mention of the grant of the patent: **08.04.2026**
(21) Application number: 23156420.4
(22) Date of filing: 13.02.2023
(51) Int. Cl.: F01P 11/02, H01M 10/6568, B60K 1/00

(54) **LIQUID REPLENISHMENT AND DRAINAGE DEVICE FOR LIQUID- COOLED ENERGY STORAGE SYSTEM AND LIQUID-COOLED ENERGY STORAGE SYSTEM**
FLÜSSIGKEITSAUFFÜLL- UND -ABLAUFVORRICHTUNG FÜR FLÜSSIGKEITSGEKÜHLTES ENERGIESPEICHERSYSTEM UND FLÜSSIGKEITSGEKÜHLTES ENERGIESPEICHERSYSTEM
DISPOSITIF DE RÉAPPROVISIONNEMENT ET DE DRAINAGE DE LIQUIDE POUR SYSTÈME DE STOCKAGE D'ÉNERGIE REFROIDI PAR LIQUIDE ET SYSTÈME DE STOCKAGE D'ÉNERGIE REFROIDI PAR LIQUIDE

(30) Priority: 02.06.2022 CN 202221392647 U
(43) Date of publication of application: 06.12.2023
(73) Proprietor: Sungrow Power Supply Co., Ltd., Hefei, Anhui 230088 (CN)
(72) Inventor: HU, Gengjun, Hefei (CN); ZHOU, Meng, Hefei (CN); FAN, Dongdong, Hefei (CN)
(74) Representative: Zacco Norway AS

(56) References cited:
- CN-A- 107 588 328
- US-A- 5 524 681
- US-A1- 2005 077 252
- US-A1- 2013 213 523
- US-B1- 6 257 285

## Description

### FIELD

The present application relates to the technical field of liquid-cooled energy storage systems, in particular to a liquid replenishment and drainage device for a liquid-cooled energy storage system and a liquid-cooled energy storage system.

### BACKGROUND

At present, most of the heat dissipation technologies of an energy storage battery are in the form of forced air cooling, and a small part thereof are in the form of liquid cooling. In a liquid-cooled energy storage system, a coolant is circulable in a pipeline, a liquid-cooled plate and a liquid-cooled unit, and the cold water prepared by a chiller is delivered to the liquid-cooled plate to take away the heat of the battery arranged on the liquid-cooled plate. Compared with an air-cooled energy storage system, the liquid-cooled energy storage system has the advantages of high energy density, low auxiliary power consumption, good temperature uniformity of the battery, etc., and gradually has a trend of replacing the air-cooled energy storage system.

The liquid-cooled energy storage system, however, needs to perform liquid replenishment and liquid drainage in occasions such as after-sales maintenance. In related technologies, the coolant is generally transferred manually, and it is difficult to replenish and drain the liquid.
US 20050077252 discloses a flush and fill process is used to ready a fuel cell cooling circuit for initial use. An external flushing system releasably connected to the cooling circuit circulates flushing coolant through the cooling circuit to remove contaminants from the wetted surfaces of the cooling circuit before the fuel cell is put into use. The flushing system includes a pump for circulating the flushing coolant through the cooling circuit, filters for removing contaminants from the coolant and a heater for elevating the temperature of the coolant. Following the flushing process to remove contaminants, the flushing system is disconnected from the cooling circuit and the cooling circuit is filled with fresh coolant.
CN 107588328A discloses a kind of coolant circulation system level pressure, fluid injection, the multifunctional integrated device of discharge opeing, include the circulation liquid case of first and second self sealss snap j oint, first and second electric two-way valve, first and second ball valve, first and second electric T-shaped valve, first and second check-valves, circulating pump, first and second filter, self priming pump, liquid reserve tank, source of solvent case and coolant circulation system, separately constitute constant pressure cycle system, the fluid injection circulatory system and the discharge opeing circulatory system. The present invention is with electric two-way valve break-make, the switching control of electric T-shaped valve direction, and realizing coolant circulation system, to integrate level pressure, fluid injection, discharge opeing multi-functional.

### SUMMARY

The present application aims to solve the problems of how to improve the liquid replenishment and drainage efficiency of a liquid-cooled energy storage system in the related art to a certain extent.

In order to solve at least one aspect of the above problems to a certain extent, a liquid replenishment and drainage device for a liquid-cooled energy storage system is provided according to a first aspect of the present application, which includes a pump, a switching power supply, a first switching valve, a check valve, a first pipeline and a quick-connect connector, ;
the first pipeline is configured to be connected with the liquid-cooled energy storage system, the pump is arranged on the first pipeline, and the pump is electrically connected with the switching power supply,
two ends of the first switching valve are respectively in communication with the first pipeline, communication positions are respectively located at two ends of the pump, and the check valve is arranged on the first pipeline and is located between the pump and one of the communication positions,
one end of the first pipeline is provided with the quick-connect connector, and the quick-connect connector is configured to be connected with the liquid-cooled energy storage system,
the first pipeline is a passage through which coolant flows into the liquid-cooled energy storage system, one end of the first pipeline (5) is connected with a liquid replenishment port of the liquid-cooled energy storage system, and the other end of the first pipeline is connected with a liquid tank through a liquid inlet, the first pipeline is a collection of multiple pipe sections,
a working voltage required by the pump is adapted through the switching power supply, the coolant can be driven by the pump to flow into the liquid-cooled energy storage system through the first pipeline when the first switching valve is closed, so as to realize the liquid replenishment of the coolant without manual liquid replenishment, during the liquid replenishment, the coolant from flowing back is prevented by the check valve when the pump is abnormal, the pump does not work when the first switching valve is opened, the coolant in the liquid-cooled energy storage system flows out from some pipe sections of the first pipeline and the first switching valve, so as to realize the liquid drainage of the coolant.

In an embodiment, the liquid replenishment and drainage device for the liquid-cooled energy storage system further includes a pressure detection unit, and the pressure detection unit is arranged at an outlet of the pump.

In an embodiment, the pressure detection unit includes a pressure switch, and the pressure switch is electrically connected with the pump.

In an embodiment, the check valve is located at an inlet of the pump;
or, the check valve is located at the outlet of the pump and is located between the pressure detection unit and the pump.

In an embodiment, the liquid replenishment and drainage device for the liquid-cooled energy storage system further includes a quick-connect connector, one end of the first pipeline is provided with the quick-connect connector, and the quick-connect connector is configured to be connected with the liquid-cooled energy storage system.

In an embodiment, the liquid replenishment and drainage device for the liquid-cooled energy storage system further includes a second switching valve, and the second switching valve is arranged on the first pipeline and is arranged close to the quick-connect connector.

In an embodiment, at least one of the first switching valve and the second switching valve is an electric valve, and the electric valve is electrically connected with the switching power supply.

In an embodiment, the pump is a direct-current self-priming pump.

In an embodiment, the liquid replenishment and drainage device for the liquid-cooled energy storage system further includes a controller, and the controller is electrically connected with the pump, the switching power supply and the first switching valve respectively.

In a second aspect, a liquid-cooled energy storage system is provided according to the present application, which includes the liquid replenishment and drainage device for the liquid-cooled energy storage system in the first aspect.

In the liquid replenishment and drainage device for the liquid-cooled energy storage system and the liquid-cooled energy storage system according to the present application, a working voltage required by the pump is adapted through the switching power supply, the coolant can be driven by the pump to flow into the liquid-cooled energy storage system through the first pipeline when the first switching valve is closed, so as to realize the liquid replenishment of the coolant without manual liquid replenishment. During the liquid replenishment, the check valve can prevent the coolant from flowing back when the pump is abnormal. The pump does not work when the first switching valve is opened, the coolant in the liquid-cooled energy storage system flows out from some pipe sections of the first pipeline and the first switching valve, so as to realize the liquid drainage of the coolant. In addition, the voltage is adjusted through the switching power supply according to the present application, for example, different input voltages are adjusted to the working voltage of the pump, which can ensure the stability of the working voltage of the pump and prevent the working voltage of the pump from being affected by the electric power system of the country or region where the liquid-cooled energy storage system is located, and avoid the risk that the liquid replenishment and drainage device for the liquid-cooled energy storage system cannot be used in countries or regions with different electric power systems, for example, the maintenance personnel such as after-sales service personnel can carry the liquid replenishment and drainage device for the liquid-cooled energy storage system according to the present application to carry out the maintenance of the liquid-cooled energy storage system in countries or regions with different electric power systems. The liquid replenishment and drainage device for the liquid-cooled energy storage system can improve the liquid supplement and drainage efficiency of the liquid-cooled energy storage system, and has strong applicability.

### BRIEF DESCRIPTION OF THE DRAWINGS

FIG. 1 is a schematic structural view of a liquid replenishment and drainage device for a liquid-cooled energy storage system according to an embodiment of the present application;
FIG. 2 is a schematic structural view of the liquid replenishment and drainage device for the liquid-cooled energy storage system according to another embodiment of the present application; and
FIG. 3 is a schematic structural view of the liquid replenishment and drainage device for the liquid-cooled energy storage system according to another embodiment of the present application.

Reference numerals are as follows:

| | | | |
|---|---|---|---|
| 1, | pump; | 2, | switching power supply; |
| 3, | first switching valve; | 4, | check valve; |
| 5, | first pipeline; | 51, | hose; |
| 6, | pressure detection unit; | 7, | quick-connect connector; |
| 8, | second switching valve; | 9, | pressure gauge; |
| 10, | filter; | 11, | liquid inlet. |

### DETAILED DESCRIPTION OF THE EMBODIMENTS

For a better understanding of the objective, technical features and advantages of the present application, specific embodiments of the present application are described in detail in conjunction with drawings.

In a description of the present application, it should be further noted that, unless otherwise explicitly specified and defined, terms such as "installation" and "connection" should be understood in a broad sense, for example, the terms may imply a fixed connection, a detachable connection, or an integral connection; a direct connection or an indirect connection through an intermediate medium. For those skilled in the art, the specific meaning of the above terms in the present application may be understood in the light of specific circumstances.

The terms "first" and "second" are only used for descriptive purposes, and should not be construed as indicating or implying relative importance or implicitly indicating the number of technical features referred to. Therefore, the features defined with "first", "second" or the like may include at least one of the features explicitly or implicitly.

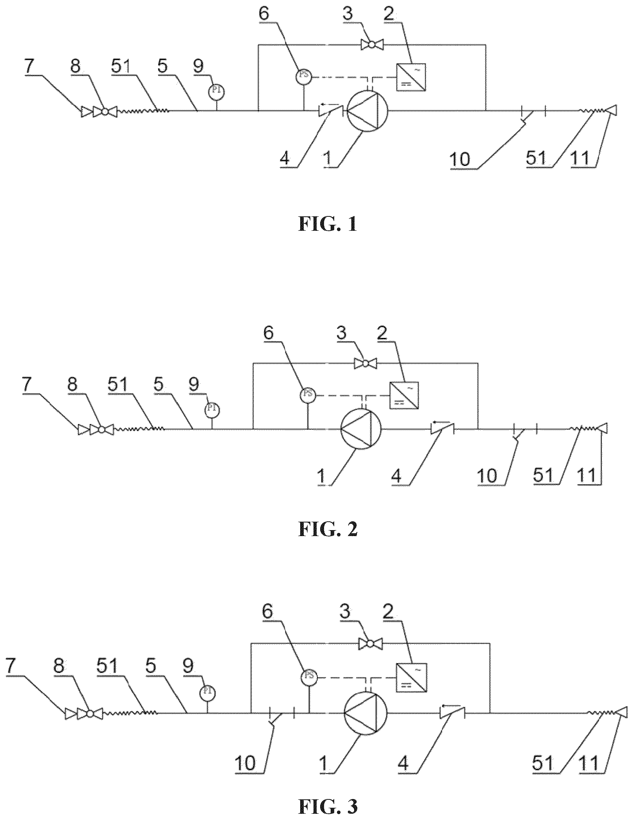

As shown in FIGS. 1 to 3, a liquid replenishment and drainage device for a liquid-cooled energy storage system is provided according to an embodiment of the present application, which includes a pump 1, a switching power supply 2, a first switching valve 3, a check valve 4 and a first pipeline 5 which is configured to be connected with the liquid-cooled energy storage system; the pump 1 is arranged on the first pipeline 5, and the pump 1 is electrically connected with the switching power supply 2;
two ends of the first switching valve 3 are respectively in communication with the first pipeline 5, communication positions are respectively located at two ends of the pump 1, and the check valve 4 is arranged on the first pipeline 5 and is located between the pump 1 and one of the communication positions.

The first pipeline 5 can be understood as a passage through which the coolant flows into the liquid-cooled energy storage system. One end of the first pipeline 5 can be connected with a liquid replenishment port of the liquid-cooled energy storage system, and the other end of the first pipeline 5 is connected with a source of the coolant, such as a liquid tank, through a liquid inlet 11. In actual use, in order to connect components such as the pump 1 or the check valve 4, the first pipeline 5 can be understood as a collection of multiple pipe sections, which is not described in detail later.

The switching power supply 2 can convert different input voltages into the working voltage of the pump 1, which can adopt relevant technologies and is not described in detail herein.

In this way, in the liquid replenishment and drainage device for the liquid-cooled energy storage system and the liquid-cooled energy storage system according to the present application, the working voltage required by the pump 1 is adapted through the switching power supply 2, the coolant can be driven by the pump 1 to flow into the liquid-cooled energy storage system through the first pipeline 5 when the first switching valve 3 is closed, so as to realize the liquid replenishment of the coolant without manual liquid replenishment. During the liquid replenishment, the check valve 4 can prevent the coolant from flowing back when the pump 1 is abnormal. The pump 1 does not work when the first switching valve 3 is opened, the coolant in the liquid-cooled energy storage system flows out from some pipe sections of the first pipeline 5 and the first switching valve 3, so as to realize the liquid drainage of the coolant. In addition, the voltage is adjusted through the switching power supply 2 according to the present application, for example, different input voltages are adjusted to the working voltage of the pump 1, which can ensure the stability of the working voltage of the pump 1 and prevent the working voltage of the pump from being affected by the electric power system of the country or region where the liquid-cooled energy storage system is located, and avoid the risk that the liquid replenishment and drainage device for the liquid-cooled energy storage system cannot be used in countries or regions with different electric power systems, for example, the maintenance personnel such as after-sales service personnel can carry the liquid replenishment and drainage device for the liquid-cooled energy storage system according to the present application to carry out the maintenance of the liquid-cooled energy storage system in countries or regions with different electric power systems. The liquid replenishment and drainage device for the liquid-cooled energy storage system can improve the liquid supplement and drainage efficiency of the liquid-cooled energy storage system, and has strong applicability.

In an optional embodiment of the present application, the liquid replenishment and drainage device for the liquid-cooled energy storage system further includes a pressure detection unit 6, and the pressure detection unit 6 is arranged at an outlet of the pump 1.

As an example, the pressure detection unit 6 includes a digital display pressure sensor, which can detect a pressure value at the outlet end of the pump 1, and the pressure detection unit 6 can further include a digital display flow sensor.

In addition, it should be noted that the pressure detection unit 6 can be integrated on the pump 1 (for example, the pump 1 provided with the pressure detection unit 6), or be arranged outside the pump 1.

In this way, the pressure value of the coolant at the outlet of the pump 1 can be detected by the pressure detection unit 6, the working of the pump 1 can be stopped when the pressure value of the coolant reaches a preset value, and the check valve 4 prevents the coolant from flowing back, so as to protect the pipeline and the pump 1.

Further, the pressure detection unit 6 includes a pressure switch, and the pressure switch is electrically connected with the pump 1.

The pressure switch is generally arranged on a power supply circuit of the pump 1, and the pump 1 stops working when the pressure switch is disconnected.

In this way, a protect value of the pressure at the outlet of the pump 1 can be set, and the pump 1 stops working when the pressure of the coolant reaches the protect value and the pressure switch is disconnected, which can realize the overpressure protection.

Further, the check valve 4 is located at an inlet (referring to FIG. 2) of the pump 1.

Alternatively, the check valve 4 is located at the outlet of the pump 1, and is located between the pressure detection unit 6 and the pump 1 (referring to FIG. 1).

In this way, the coolant can be prevented from flowing back, and the pressure change of the coolant can be detected by the pressure detection unit 6 after the pump 1 stops working.

On this basis, a pressure gauge 9 can be arranged on the first pipeline 5, which facilitates the user to observe the pressure of the coolant.

Referring to FIG. 1, the liquid replenishment and drainage device for the liquid-cooled energy storage system further includes a quick-connect connector 7, one end of the first pipeline 5 is provided with the quick-connect connector 7, and the quick-connect connector 7 is configured to be connected with the liquid-cooled energy storage system.

At this time, the quick-connect connector 7 is located at an end of the first pipeline 5 in an outlet direction of the pump 1. Relevant prior art can be adopted for the quick-connect connector 7, which is adapted to the connector on the liquid-cooled energy storage system, such as the liquid replenishment port. For example, the quick-connect connector 7 is a press-type connector.

In this way, the liquid replenishment and drainage device for the liquid-cooled energy storage system can be quickly connected with the liquid-cooled energy storage system through the quick-connect connector 7, so as to improve the operation efficiency.

Referring to FIG. 1, in an embodiment, the liquid replenishment and drainage device for the liquid-cooled energy storage system further includes a second switching valve 8, which is arranged on the first pipeline 5 and is arranged close to the quick-connect connector 7.

When needed, for example, the pump 1 or the first switching valve 3 is abnormal, the second switching valve 8 can quickly and integrally cut off the first pipeline 5 and the first switching valve 3 at a position close to the liquid-cooled energy storage system (that is, at the quick-connect connector 7), so as to prevent the cooling oil from flowing into or flowing out of the liquid-cooled energy storage system.

Further, at least one of the first switching valve 3 and the second switching valve 8 is an electric valve, and the electric valve is electrically connected with the switching power supply 2.

Taking the first switching valve 3 as an example, the first switching valve 3 is a valve with two states of open and closed, but it can also have other states. For example, it may be arranged as a regulating valve with two states of open and closed and an adjustable opening at a valve port, for example, the first switching valve 3 may be arranged as an electric ball valve, which is not described in detail herein.

The action of the first switching valve 3 and subsequent similar electric valves can be controlled manually or by a controller later on, which is not described in detail herein.

In this way, at least one of the first switching valve 3 and the second switching valve 8 is an electric valve and is energized by the switching power supply 2, which can reduce the workload of maintenance personnel.

In the above embodiments, optionally, the liquid replenishment and drainage device for the liquid-cooled energy storage system further includes a controller, which is electrically connected with the pump 1, the switching power supply 2 and the first switching valve 3 respectively.

The controller can be electrically connected with the second switching valve 8 and the pressure detection unit 6.

In this way, the linkage control between devices can be realized through the controller. For example, during first usage, when the first switching valve 3 is in the open state, the controller can control the pump 1 to be in a non-working state, and when the first switching valve 3 is in the closed state, the controller can control the pump 1 to work.

In addition, when the detection pressure of the pressure detection unit 6 exceeds a safety pressure, the controller can control the pump 1 to stop working, and the controller can control the first switching valve 3 to open, so as to realize pressure relief. For example, the control of the pump 1 fails to stop working, the controller can control the first switching valve 3 to open, so as to ensure the safety use.

In the above embodiments, optionally, the pump 1 is a direct-current self-priming pump.

In this way, the pump 1 has a small volume and a high safety, which does not need to add water every time it is used.

It should be noted that the liquid replenishment and drainage device for the liquid-cooled energy storage system can further include other components such as a filter 10 (referring to FIG. 2 and FIG. 3), and the filter 10 is arranged on the first pipeline 5.

In addition, some pipe sections of the first pipeline 5 can be arranged as a hose 51, which are not limited.

Referring to FIG. 1, the usage method of the liquid replenishment and drainage device for the liquid-cooled energy storage system is illustrated as follows:
when liquid replenishment is required, the quick-connect connector 7 is connected with the liquid-cooled energy storage system, the first switching valve 3 is closed, the second switching valve 8 is opened, and the coolant flows into the liquid-cooled energy storage system through the liquid inlet 11, the filter 10, the check valve 4, the pump 1, the second switching valve 8 and the quick-connect connector 7.

When liquid drainage is required, the first switching valve 3 is closed, the second switching valve 8 is opened, and the coolant in the liquid-cooled energy storage system flows out through the quick-connect connector 7, the first switching valve 3, the filter 10 and the liquid inlet 11.

The liquid-cooled energy storage system according to the present application includes the liquid replenishment and drainage device for the liquid-cooled energy storage system.

The liquid-cooled energy storage system has all the beneficial effects of the liquid replenishment and drainage device for the liquid-cooled energy storage system, which is not described in detail herein.

## Claims

1. A liquid replenishment and drainage device for a liquid-cooled energy storage system, comprising a pump (1), a switching power supply (2), a first switching valve (3), a check valve (4), a first pipeline (5) which is configured to be connected with the liquid-cooled energy storage system, and a quick-connect connector (7);
wherein the pump (1) is arranged on the first pipeline (5), and the pump (1) is electrically connected with the switching power supply (2);
two ends of the first switching valve (3) are respectively in communication with the first pipeline (5), communication positions are respectively located at two ends of the pump (1), and the check valve (4) is arranged on the first pipeline (5) and is located between the pump (1) and one of the communication positions,
wherein one end of the first pipeline (5) is provided with the quick-connect connector (7), and the quick-connect connector (7) is configured to be connected with the liquid-cooled energy storage system, the first pipeline (5) is a passage through which coolant flows into the liquid-cooled energy storage system, one end of the first pipeline (5) is connected with a liquid replenishment port of the liquid-cooled energy storage system, and the other end of the first pipeline (5) is connected with a source of the coolant, such as a liquid tank, through a liquid inlet (11), the first pipeline (5) is a collection of multiple pipe sections,
a working voltage required by the pump (1) is adapted through the switching power supply (2), the coolant can be driven by the pump (1) to flow into the liquid-cooled energy storage system through the first pipeline (5) when the first switching valve (3) is closed, so as to realize the liquid replenishment of the coolant without manual liquid replenishment, during the liquid replenishment, the coolant from flowing back is prevented by the check valve (4) when the pump (1) is abnormal, the pump (1) does not work when the first switching valve (3) is opened, the coolant in the liquid-cooled energy storage system flows out from some pipe sections of the first pipeline (5) and the first switching valve (3), so as to realize the liquid drainage of the coolant.

2. The liquid replenishment and drainage device for the liquid-cooled energy storage system according to claim 1, further comprising a pressure detection unit (6), wherein the pressure detection unit (6) is arranged at an outlet of the pump (1).

3. The liquid replenishment and drainage device for the liquid-cooled energy storage system according to claim 2, wherein the pressure detection unit (6) comprises a pressure switch, and the pressure switch is electrically connected with the pump (1).

4. The liquid replenishment and drainage device for the liquid-cooled energy storage system according to claim 3, wherein the check valve (4) is located at an inlet of the pump (1);
or, the check valve (4) is located at the outlet of the pump (1) and is located between the pressure detection unit (6) and the pump (1).

5. The liquid replenishment and drainage device for the liquid-cooled energy storage system according to claim 1, further comprising a second switching valve (8), wherein the second switching valve (8) is arranged on the first pipeline (5) and is arranged close to the quick-connect connector (7).

6. The liquid replenishment and drainage device for the liquid-cooled energy storage system according to claim 5, wherein at least one of the first switching valve (3) and the second switching valve (8) is an electric valve, and the electric valve is electrically connected with the switching power supply (2).

7. The liquid replenishment and drainage device for the liquid-cooled energy storage system according to any one of claims 1 to 6, wherein the pump (1) is a direct-current self-priming pump.

8. The liquid replenishment and drainage device for the liquid-cooled energy storage system according to any one of claims 1 to 6, further comprising a controller, wherein the controller is electrically connected with the pump (2), the switching power supply (2) and the first switching valve (3).

9. A liquid-cooled energy storage system, comprising the liquid replenishment and drainage device for the liquid-cooled energy storage system according to any one of claims 1 to 8.

## Patentansprüche

1. Flüssigkeitsauffüll- und -ablaufvorrichtung für ein flüssigkeitsgekühltes Energiespeichersystem, umfassend eine Pumpe (1), eine Umschaltstromversorgung (2), ein erstes Umschaltventil (3), ein Sperrventil (4), eine erste Pipeline (5), die dazu konfiguriert ist, mit dem flüssigkeitsgekühlten Energiespeichersystem verbunden zu werden, und einen Schnellverbinder (7);
wobei die Pumpe (1) an der ersten Pipeline (5) angeordnet ist und die Pumpe (1) elektrisch mit der Umschaltstromversorgung (2) verbunden ist;
wobei zwei Enden des ersten Umschaltventils (3) jeweils in Verbindung mit der ersten Pipeline (5) stehen, sich die Verbindungspositionen jeweils an zwei Enden der Pumpe (1) befinden und das Sperrventil (4) an der ersten Pipeline (5) angeordnet ist und sich zwischen der Pumpe (1) und einer der Verbindungspositionen befindet,
wobei ein Ende der ersten Pipeline (5) mit dem Schnellverbinder (7) versehen ist und der Schnellverbinder (7) dazu konfiguriert ist, mit dem flüssigkeitsgekühlten Energiespeichersystem verbunden zu werden, die erste Pipeline (5) ein Kanal ist, durch welchen Kühlmittel in das flüssigkeitsgekühlte Energiespeichersystem strömt, ein Ende der ersten Pipeline (5) mit einem Flüssigkeitsauffüllanschluss des flüssigkeitsgekühlten Energiespeichersystems verbunden ist und das andere Ende der ersten Pipeline (5) durch einen Flüssigkeitseinlass (11) mit einer Quelle des Kühlmittels, wie etwa einem Flüssigkeitstank, verbunden ist, die erste Pipeline (5) eine Ansammlung mehrerer Rohrabschnitte ist,
wobei eine für die Pumpe (1) erforderliche Arbeitsspannung durch die Umschaltstromversorgung (2) angepasst wird, das Kühlmittel durch die Pumpe (1) angetrieben werden kann, damit es durch die erste Pipeline (5) in das flüssigkeitsgekühlte Energiespeichersystem strömt, wenn das erste Umschaltventil (3) geschlossen ist, um so die Flüssigkeitsauffüllung des Kühlmittels ohne manuelle Flüssigkeitsauffüllung zu realisieren, das Kühlmittel während der Flüssigkeitsauffüllung durch das Sperrventil (4) am Zurückströmen gehindert wird, wenn die Pumpe (1) anormal ist, die Pumpe (1) nicht arbeitet, wenn das erste Umschaltventil (3) geöffnet ist, das Kühlmittel in dem flüssigkeitsgekühlten Energiespeichersystem aus einigen Rohrabschnitten der ersten Pipeline (5) und dem ersten Umschaltventil (3) strömt, um so den Flüssigkeitsablauf des Kühlmittels zu realisieren.

2. Flüssigkeitsauffüll- und -ablaufvorrichtung für das flüssigkeitsgekühlte Energiespeichersystem nach Anspruch 1, ferner umfassend eine Druckerfassungseinheit (6), wobei die Druckerfassungseinheit (6) an einem Auslass der Pumpe (1) angeordnet ist.

3. Flüssigkeitsauffüll- und -ablaufvorrichtung für das flüssigkeitsgekühlte Energiespeichersystem nach Anspruch 2, wobei die Druckerfassungseinheit (6) einen Druckschalter umfasst und der Druckschalter elektrisch mit der Pumpe (1) verbunden ist.

4. Flüssigkeitsauffüll- und -ablaufvorrichtung für das flüssigkeitsgekühlte Energiespeichersystem nach Anspruch 3, wobei sich das Sperrventil (4) an einem Einlass der Pumpe (1) befindet;
oder sich das Sperrventil (4) an dem Auslass der Pumpe (1) befindet und sich zwischen der Druckerfassungseinheit (6) und der Pumpe (1) befindet.

5. Flüssigkeitsauffüll- und -ablaufvorrichtung für das flüssigkeitsgekühlte Energiespeichersystem nach Anspruch 1, ferner umfassend ein zweites Umschaltventil (8), wobei das zweite Umschaltventil (8) an der ersten Pipeline (5) angeordnet ist und in der Nähe des Schnellverbinders (7) angeordnet ist.

6. Flüssigkeitsauffüll- und -ablaufvorrichtung für das flüssigkeitsgekühlte Energiespeichersystem nach Anspruch 5, wobei mindestens eines des ersten Umschaltventils (3) und des zweiten Umschaltventils (8) ein elektrisches Ventil ist und das elektrische Ventil elektrisch mit der Umschaltstromversorgung (2) verbunden ist.

7. Flüssigkeitsauffüll- und -ablaufvorrichtung für das flüssigkeitsgekühlte Energiespeichersystem nach einem der Ansprüche 1 bis 6, wobei die Pumpe (1) eine selbstansaugende Gleichstrompumpe ist.

8. Flüssigkeitsauffüll- und -ablaufvorrichtung für das flüssigkeitsgekühlte Energiespeichersystem nach einem der Ansprüche 1 bis 6, ferner umfassend eine Steuerung, wobei die Steuerung elektrisch mit der Pumpe (2), der Umschaltstromversorgung (2) und dem ersten Umschaltventil (3) verbunden ist.

9. Flüssigkeitsgekühltes Energiespeichersystem, umfassend die Flüssigkeitsauffüll- und -ablaufvorrichtung für das flüssigkeitsgekühlte Energiespeichersystem nach einem der Ansprüche 1 bis 8.

## Revendications

1. Dispositif de réapprovisionnement et de drainage de liquide pour système de stockage d'énergie refroidi par liquide, comprenant une pompe (1), une alimentation à découpage (2), une première vanne de commutation (3), un clapet anti-retour (4), une première canalisation (5) qui est configurée pour être raccordée au système de stockage d'énergie refroidi par liquide, et un connecteur à raccord rapide (7) ;
dans lequel la pompe (1) est disposée sur la première canalisation (5), et la pompe (1) est connectée électriquement à l'alimentation à découpage (2) ;
deux extrémités de la première vanne de commutation (3) sont respectivement en communication avec la première canalisation (5), des positions de communication sont respectivement situées aux deux extrémités de la pompe (1), et le clapet anti-retour (4) est disposé sur la première canalisation (5) et est situé entre la pompe (1) et l'une des positions de communication,
dans lequel une extrémité de la première canalisation (5) est pourvue du connecteur à raccord rapide (7), et le connecteur à raccord rapide (7) est configuré pour être raccordé au système de stockage d'énergie refroidi par liquide, la première canalisation (5) est un passage à travers lequel du liquide de refroidissement s'écoule dans le système de stockage d'énergie refroidi par liquide, une extrémité de la première canalisation (5) est raccordée à un orifice de réapprovisionnement en liquide du système de stockage d'énergie refroidi par liquide, et l'autre extrémité de la première canalisation (5) est raccordée à une source du liquide de refroidissement, telle qu'un réservoir de liquide, par l'intermédiaire d'une entrée de liquide (11), la première canalisation (5) est un ensemble de multiples sections de tube,
une tension de fonctionnement requise par la pompe (1) est adaptée par l'intermédiaire de l'alimentation à découpage (2), le liquide de refroidissement peut être entraîné par la pompe (1) pour s'écouler dans le système de stockage d'énergie refroidi par liquide à travers la première canalisation (5) lorsque la première vanne de commutation (3) est fermée, de manière à réaliser le réapprovisionnement en liquide du liquide de refroidissement sans réapprovisionnement manuel en liquide, pendant le réapprovisionnement en liquide, le retour du liquide de refroidissement est empêché par le clapet anti-retour (4) lorsque la pompe (1) est anormale, la pompe (1) ne fonctionne pas lorsque la première vanne de commutation (3) est ouverte, le liquide de refroidissement dans le système de stockage d'énergie refroidi par liquide s'écoule hors de certaines sections de tube de la première canalisation (5) et de la première vanne de commutation (3), de manière à réaliser le drainage de liquide du liquide de refroidissement.

2. Dispositif de réapprovisionnement et de drainage de liquide pour système de stockage d'énergie refroidi par liquide selon la revendication 1, comprenant en outre une unité de détection de pression (6), dans lequel l'unité de détection de pression (6) est disposée à une sortie de la pompe (1).

3. Dispositif de réapprovisionnement et de drainage de liquide pour système de stockage d'énergie refroidi par liquide selon la revendication 2, dans lequel l'unité de détection de pression (6) comprend un pressostat, et le pressostat est connecté électriquement à la pompe (1).

4. Dispositif de réapprovisionnement et de drainage de liquide pour système de stockage d'énergie refroidi par liquide selon la revendication 3, dans lequel le clapet anti-retour (4) est situé à une entrée de la pompe (1) ;
ou, le clapet anti-retour (4) est situé à la sortie de la pompe (1) et est situé entre l'unité de détection de pression (6) et la pompe (1).

5. Dispositif de réapprovisionnement et de drainage de liquide pour système de stockage d'énergie refroidi par liquide selon la revendication 1, comprenant en outre une seconde vanne de commutation (8), dans lequel la seconde vanne de commutation (8) est disposée sur la première canalisation (5) et est disposée à proximité du connecteur à raccord rapide (7).

6. Dispositif de réapprovisionnement et de drainage de liquide pour système de stockage d'énergie refroidi par liquide selon la revendication 5, dans lequel au moins l'une de la première vanne de commutation (3) et de la seconde vanne de commutation (8) est une vanne électrique, et la vanne électrique est connectée électriquement à l'alimentation à découpage (2).

7. Dispositif de réapprovisionnement et de drainage de liquide pour système de stockage d'énergie refroidi par liquide selon l'une quelconque des revendications 1 à 6, dans lequel la pompe (1) est une pompe auto-amorçante à courant continu.

8. Dispositif de réapprovisionnement et de drainage de liquide pour système de stockage d'énergie refroidi par liquide selon l'une quelconque des revendications 1 à 6, comprenant en outre un dispositif de commande, dans lequel le dispositif de commande est connecté électriquement à la pompe (1), à l'alimentation à découpage (2) et à la première vanne de commutation (3).

9. Système de stockage d'énergie refroidi par liquide, comprenant le dispositif de réapprovisionnement et de drainage de liquide pour système de stockage d'énergie refroidi par liquide selon l'une quelconque des revendications 1 à 8.
